(19) **Europäisches Patentamt**
**European Patent Office**
**Office européen des brevets**

(11) **EP 2 133 170 A1**

(12) **EUROPEAN PATENT APPLICATION**

(43) Date of publication:
**16.12.2009 Bulletin 2009/51**

(51) Int Cl.:
**B23K 26/18** (2006.01)    **B23K 26/40** (2006.01)
**C09J 7/02** (2006.01)    **H01L 21/68** (2006.01)
**H01L 21/78** (2006.01)

(21) Application number: **09007723.1**

(22) Date of filing: **10.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **11.06.2008 JP 2008153288**

(71) Applicant: **Nitto Denko Corporation**
**Ibaraki-shi,**
**Osaka 567-8680 (JP)**

(72) Inventors:
• **Takahashi, Tomokazu**
**Ibaraki-shi,**
**Osaka 567-8680 (JP)**
• **Asai, Fumiteru**
**Ibaraki-shi,**
**Osaka 567-8680 (JP)**
• **Higashibeppu, Yuki**
**Ibaraki-shi,**
**Osaka 567-8680 (JP)**

(74) Representative: **Müller-Boré & Partner**
**Patentanwälte**
**Grafinger Strasse 2**
**81671 München (DE)**

(54) **Pressure-sensitive adhesive sheet for UV laser processing and UV laser processing method**

(57) In performing the laser processing of a workpiece (1) with laser light (6), there are provided a pressure-sensitive adhesive sheet (2) for laser processing and a laser processing method that can perform the laser processing of a workpiece (1) easily with good production efficiency by preventing the fusion of a substrate (2b) and an adsorption stage. According to the invention, an pressure-sensitive adhesive sheet (2) for laser processing that is used for laser processing of a workpiece (1) with laser light (6) having a wavelength in an ultraviolet region or with laser light (6) that enables light absorption in an ultraviolet region that has passed a multiphoton absorption process, comprising a substrate (2b) and an pressure-sensitive adhesive layer (2a) disposed on one surface of the substrate (2b), wherein a melting point of the substrate at another surface is 80°C or higher, and an etching rate (etching speed / energy fluence) in a case of radiating the laser light (6) onto the other surface is 0.1 [($\mu$m /pulse) / (J/cm$^2$)] or lower.

【Fig. 1】

**Description**

The present invention relates to an pressure-sensitive adhesive sheet for laser processing that is used for laser processing of a workpiece with laser light having a wavelength in an ultraviolet region or with laser light that enables light absorption in an ultraviolet region that has passed a multiphoton absorption process. Further, the present invention relates to a manufacturing method of laser processed parts for machining works such as various sheet materials, circuit boards, semiconductor wafers, glass substrates, ceramic substrates, metal substrates, semiconductor laser or other light emitting or receiving element substrates, MEMS substrates, semiconductor packages, cloth, leather, paper or the like, by using laser, by cutting, drilling, marking, grooving, scribing, trimming, or other shaping process, and a pressure-sensitive adhesive sheet for laser processing used for this purpose.

In accordance with the scale reduction of electric and electronic apparatus of recent years, components thereof are downsized and made highly fine. For this reason, in a cutting process of various materials, high fineness and high precision are demanded. In particular, in the field of semiconductors which has high demands of scale reduction and high density, a processing method of semiconductor wafers using laser light that enables processing with a high fineness with little heat damage is focused in recent years.

As a processing method of a semiconductor wafer (workpiece) using laser light, there is, for example, a method of forming semiconductor chips by fixing onto a dicing sheet a semiconductor wafer subjected to various circuit formations and surface treatments and dicing this semiconductor wafer with laser light (See, for example, Japanese Patent Application Laid-open No. 2004-79746). Also, as a dicing sheet that is used for a cutting process of a semiconductor wafer using laser light, a dicing sheet is proposed that is constructed with a substrate containing a supporting sheet and an pressure-sensitive adhesive layer formed on a surface of this substrate where the pressure-sensitive adhesive layer can be cut with laser light but the substrate film is not cut (See, for example, Japanese Patent Application Laid-open No. 2002-393797).

However, when a conventional dicing sheet is used for laser processing, the laser light may sometimes be transmitted through the dicing sheet to thermally melt or deform the side of the substrate on which the pressure-sensitive adhesive layer is not disposed. As a result of this, the adsorption stage on which the dicing sheet is mounted and the substrate is fused, making it impossible to transport the semiconductor chips after dicing.

The present invention has been made in view of the aforementioned conventional problems, and an object thereof is to provide, in performing the laser processing of a workpiece with laser light, an pressure-sensitive adhesive sheet for laser processing and a laser processing method that can perform the laser processing of the workpiece easily with a good production efficiency by preventing the fusion of a substrate and an adsorption stage.

The inventors of the present application and others have studied a pressure-sensitive adhesive sheet for laser processing and a laser processing method in order to solve the aforementioned conventional problems. As a result thereof, by focusing on the physical property of the surface of the substrate on which the pressure-sensitive adhesive layer is not disposed in an pressure-sensitive adhesive sheet for laser processing, the aforementioned object can be achieved by having the pressure-sensitive adhesive sheet for laser processing to be configured as below, thereby completing the present invention.

That is, in order to solve the problems, an pressure-sensitive adhesive sheet for laser processing that is used for laser processing of a workpiece with laser light having a wavelength in an ultraviolet region or with laser light that enables light absorption in an ultraviolet region that has passed a multiphoton absorption process, comprising a substrate and an pressure-sensitive adhesive layer disposed on one surface of the substrate, wherein a melting point of the substrate at another surface is 80°C or higher, and an etching rate (etching speed / energy fluence) in a case of radiating the laser light onto the other surface is 0.1 [($\mu$m /pulse) / (J/cm$^2$)] or lower.

With the above-described configuration, a melting point of 80°C or higher of the surface (back surface) of the substrate on which the pressure-sensitive adhesive layer is not disposed restrains the back surface of the substrate from being thermally melted by the heat even if laser light is transmitted through the pressure-sensitive adhesive sheet. Also, 0.1 [($\mu$m/pulse) / (J/cm$^2$)] or lower of the etching rate in a case of radiating the laser light onto the back surface of the substrate restrains the back surface of the substrate from being deformed by the laser light. This prevents, for example, the fusion of the substrate to the adsorption stage for mounting the pressure-sensitive adhesive sheet for laser processing, thereby improving the yield of production and the production efficiency. Also, there is no need to reduce the power of the laser light in order to prevent the fusion of the substrate to the adsorption stage. As a result of this, the laser light can be made to have a high power thereby to improve the throughput.

Here, the etching speed in the present invention refers to the etched thickness of the substrate that is etched per one pulse when laser light having a wavelength in an ultraviolet region or laser light that enables light absorption in an ultraviolet region that has passed a multiphoton absorption process is radiated onto the surface of the substrate on which the pressure-sensitive adhesive layer is not disposed, under a predetermined condition. Also, the energy fluence refers to the energy (joule: J) of the laser light that is put in by one pulse per unit area (square centimeter: cm$^2$) in a region in which the laser light is radiated onto the surface of the substrate.

In the above-described invention, a light absorption coefficient of the substrate is 10 (1 / cm) or lower for the laser light having a predetermined oscillation wavelength. When the light absorption coefficient of the substrate relative to the laser light having the predetermined oscillation wavelength is 10 (1 /cm) or less, the absorption of the laser light by the substrate is restrained, thereby making the generation of ablation less liable to occur. This can prevent the excessive heating of the substrate caused by the ablation of the substrate and further prevent the thermal melting of the back surface of the substrate.

In the above-described configuration, the substrate is a laminate, and a layer made of polyethylene is disposed on the other surface side. The etching rate of the layer made of polyethylene relative to the laser light is extremely low. For this reason, by laminating a layer made of polyethylene on the back surface side of the substrate, the back surface of the substrate can be made to be further hardly processable. Also, since the generation of polyethylene decomposition products is restrained, the back surface side of the substrate is restrained from being contaminated.

Further, in order to solve the problems, a laser processing method using an pressure-sensitive adhesive sheet for laser processing as set forth in claim 1 by radiating onto a workpiece laser light having a wavelength in an ultraviolet region or laser light that enables light absorption in an ultraviolet region that has passed a multiphoton absorption process, so as to process the workpiece by ablation, comprising a step of bonding the pressure-sensitive adhesive sheet for laser processing onto the workpiece through the intermediary of the pressure-sensitive adhesive layer, and a step of processing the workpiece by radiating onto the workpiece the laser light having a radiation intensity of a threshold value that induces at least the ablation of the workpiece or higher.

In the present configuration, since the pressure-sensitive adhesive sheet for laser processing described above is used, the thermal melting or deformation of the back surface of the substrate by the laser light is prevented. As a result of this, for example, the substrate is prevented from being fused to the adsorption stage for mounting the pressure-sensitive adhesive sheet for laser processing, thereby enabling the laser processing of the workpiece with an improved yield.

Also, since laser light having a wavelength in an ultraviolet region or laser light that enables light absorption in an ultraviolet region that has passed a multiphoton absorption process is used, the processing can be made by photochemical ablation without passing through a heat treatment process. This enables sharp processing of the cut portions or openings without thermal damage to the edge part, thereby improving the processing precision and the reliability. Further, local condensation of light can be made as compared with laser light in an infrared region, thereby eliminating the need for providing a large cutting margin. Therefore, laser processing can be made with a smaller cutting margin as compared with a conventional case.

Further, in the present invention, with use of the above-described pressure-sensitive adhesive sheet for laser processing, the fusion of the substrate to the adsorption stage can be prevented, thereby eliminating the need for reducing the power of the laser light. This enables the laser light to have a high power thereby to improve the throughput.

In the present process, the workpiece is a semiconductor wafer, and semiconductor chips are formed by splitting the semiconductor wafer into individual pieces by radiation of the laser light. As described above, the laser processing method according to the present invention uses a pressure-sensitive adhesive sheet provided with a pressure-sensitive adhesive layer for bonding and fixing a workpiece as the pressure-sensitive adhesive sheet. Therefore, even in a case in which a predetermined region of the workpiece is subjected to a cutting process at a time, for example, the cut products (cut pieces) remain bonded and fixed to the pressure-sensitive adhesive layer. For this reason, the cut products can be prevented from being dropped off, thereby improving the handling property. Further, there is no need to adopt a technique of preventing the drop-off by partly leaving the unprocessed parts. As a result of this, when a semiconductor wafer is applied as the workpiece, the semiconductor chips can be fabricated while restraining the generation of the chip flying.

The present invention produces the following effects by the above-described means. In other words, according to the present invention, since the surface (back surface) of the substrate on which the pressure-sensitive adhesive layer is not disposed has a melting point of 80°C or higher, the back surface of the substrate is restrained from being-thermally melted by the heat of the laser light. Also, since the etching rate in a case of radiating the laser light onto the back surface of the substrate is set to be 0.1 [(μm /pulse) / (J/cm$^2$)] or lower, the back surface of the substrate is restrained from being deformed by the laser light. This prevents, for example, the fusion of the substrate to the adsorption stage for mounting the pressure-sensitive adhesive sheet for laser processing, thereby improving the yield of production and the production efficiency.

Fig. 1 is a cross-sectional model view for describing the laser processing of a workpiece according to an embodiment of the present invention;

Fig. 2 is a schematic view for describing a laser processing method according to the embodiment;

Fig. 3 is a schematic view for describing another laser processing method of a workpiece according to the embodiment;

Fig. 4 is a cross-sectional model view for describing the laser processing of a workpiece according to the embodiment;

and

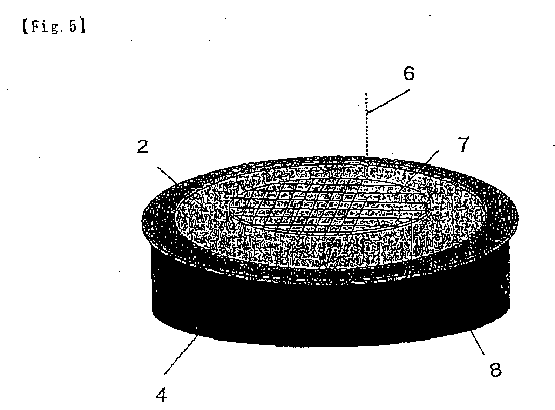

Fig. 5 is a schematic view illustrating an example of a dicing method of a semiconductor wafer.

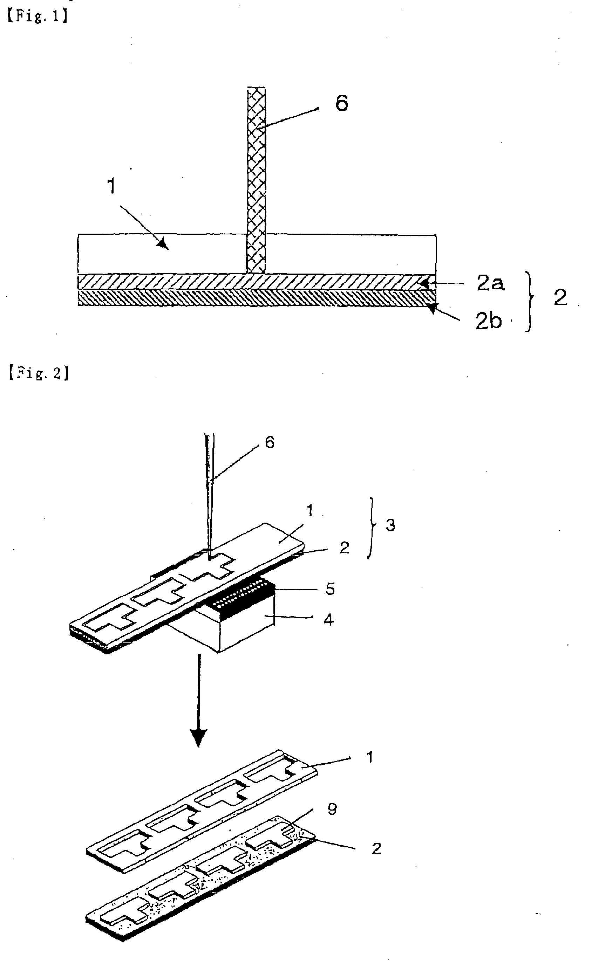

A method of producing a laser-processed product according to Embodiment 1 of the present invention will be described with reference to Figs. 1 to 4. However, parts unnecessary for the description have been omitted, and there are some parts that are illustrated in enlargement or diminishment for facilitating the description.

First, a pressure-sensitive adhesive sheet for laser processing (hereafter referred to as "pressure-sensitive adhesive sheet") according to the present embodiment will be described. As shown in Fig. 1, the pressure-sensitive adhesive sheet 2 according to the present embodiment has a configuration such that a pressure-sensitive adhesive layer 2a is laminated on a substrate 2b. The pressure-sensitive adhesive sheet 2 is mounted on an adsorption stage with the substrate 2b facing downwards, and is used for bonding and fixing a workpiece 1 with use of the pressure-sensitive adhesive layer 2a, and for supporting and fixing the workpiece 1 on the adsorption stage during the laser processing and in each of the subsequent steps.

The back surface side of the substrate 2b, namely the surface side on which the pressure-sensitive adhesive layer 2a is not disposed, has a melting point of 80°C or higher, preferably 90°C or higher, more preferably 95°C or higher. Setting the melting point to be 80°C or higher restrains the back surface of the substrate 2b from being thermally melted by the heat even when the laser light is transmitted through the pressure-sensitive adhesive sheet 2. Provided that, in consideration of the moldability, the upper limit of the melting point is preferably 150°C or lower.

Also, the etching rate (etching speed / energy fluence) of the back surface side of the substrate 2b when the laser light is radiated under a predetermined condition is 0.1 $[(\mu m$ /pulse) / $(J/cm^2)]$ or lower, preferably 0.07 $[(\mu m$ /pulse) / $(J/cm^2)]$ or lower, more preferably 0.05 $[(\mu m$ /pulse) / $(J/cm^2)]$ or lower. Setting the etching rate to be 0.1 $[(\mu m$ /pulse) / $(J/cm^2)]$ or lower enables to restrain the back surface of the substrate 2b from being deformed even when the laser light is transmitted through the pressure-sensitive adhesive sheet 2. Here, the radiation condition of the aforesaid laser light is, for example, as shown in the later-described examples.

The substrate 2b may be a single layer or a laminate obtained by lamination of a plurality of layers. In the case of a laminate, the present invention is not limited as long as the topmost layer disposed on the back surface side of the substrate 2b has a melting point of 80°C or higher and the etching rate is 0.1 $[(\mu m$ /pulse) / $(J/cm^2)]$ or lower. Also, for the substrate 2b, those having various shapes can be selected such as in a film form or a mesh form. In particular, a substrate having a large porosity ratio is preferable such as in a fiber form, a non-woven cloth, a woven cloth, or a porous body of the later described constituent materials.

Also, the light absorption coefficient of the substrate 2b is preferably 10 (1 / cm) or lower, more preferably 8 (1 / cm) or lower, still more preferably 5 (1 / cm) or lower, relative to the laser light having a predetermined oscillation wavelength. This restrains the absorption of the laser light by the substrate to make the generation of ablation less liable to occur. As a result of this, the excessive heating of the substrate is prevented, thereby further preventing the thermal melting of the back surface of the substrate. Also, the oscillation wavelength of the laser light is not particularly limited, and it means, for example, an oscillation wavelength in various kinds of laser light described later.

The construction material for the substrate 2b includes, but not particularly limited to, polyethylene terephthalate, polyethylene naphthalate, polystyrene, polycarbonate, polyimide, (meth)acrylic-based polymer, polyurethane-based resin, polynorbornene-based resin, polyalkylene glycol-based resins such as polyethylene glycol and polytetramethylene glycol, silicone-based rubber, and polyolefin-based resins such as polyethylene, polypropylene, polybutadiene, polyvinyl alcohol, and polymethylpentene, as examples.

Among the above-exemplified construction materials, it is preferable to use a polyolefin-based resin in the present invention, and in particular, polyethylene is preferable. Polyethylene does not have a functional group in the side chain, and for this reason, has an extremely low etching rate to the laser light. Namely, polyethylene shows an especially hard processability against the laser processing, so that the generation of the polyethylene decomposition products can be effectively restrained. As a result of this, for example, staining of the back surface side of the substrate 2b with the attachment of the polyethylene decomposition products can be reduced, Here, in the event that the substrate 2b is a laminate, it is sufficient that at least the resin layer on the back surface side is a layer made of polyethylene.

In the case in which the substrate 2b is a laminate, the method of forming a layer made of polyethylene or the like on the back surface side thereof is not particularly limited, and a conventionally known method may be adopted. Specifically, one can raise dry lamination, casting, coextrusion, surface coating, and the like as examples.

The thickness (which means the total thickness in the case of a laminate) of the substrate 2b can be set by making suitable selection within a range that does not deteriorate the operability and the workability in each of the steps of bonding to the workpiece 1, cutting of the workpiece 1, peeling-off and collection of the cut pieces, and the like. Typically, the thickness of the substrate 2b is set to be 500 $\mu m$ or less, preferably about 5 to 300 $\mu m$, more preferably about 10 to 250 $\mu m$. When the substrate 2b is a laminate, the thickness of the layer made of polyethylene or the like that is disposed on the back surface side is not particularly limited, and is suitably set in accordance with the needs. Preferably, the thickness is 5 $\mu m$ or more, more preferably 10 $\mu m$ or more.

A commonly used surface treatment can be carried out on the back surface side of the substrate 2b in order to enhance the adhesion to the adjacent layers such as the adsorption stage, the retainability, and the like. Such a surface treatment may be, for example, a chemical or physical treatment such as chromic acid treatment, exposure to ozone, exposure to fire, exposure to high-voltage electric shock, or ionized radiation treatment, a coating treatment using an anchor coat agent (for example, a later-mentioned pressure-sensitive adhesive substance), or the like.

The examples of pressure-sensitive adhesive layer 2a include those formed by a known pressure-sensitive adhesive agent containing a (meth) acrylic polymer or a rubber-based polymer. The acrylic pressure-sensitive adhesive may be, for example, a (meth) acrylic-based polymer such as a polymer of (meth) acrylic acid alkyl ester or a copolymer obtained by copolymerizing a copolymerizable monomer with (meth) acrylic acid alkyl ester for the purpose of reforming such as the adherability, the cohesive strength, or the heat resistance in accordance with the needs. Here, the (meth) acrylic acid alkyl ester means acrylic acid ester and/or methacrylic acid ester, and the term (meth) in the present invention all has the same meaning.

The (meth)acrylic polymer may be, for example, an alkyl (meth)acrylate containing a straight-chain or branched alkyl group having a carbon number of 30 or less, preferably from 3 to 18, such as methyl group, ethyl group, n-propyl group, isopropyl group, n-butyl group, t-butyl group, isobutyl group, amyl group, isoamyl group, hexyl group, heptyl group, cyclohexyl group, 2-ethylhexyl group, octyl group, isooctyl group, nonyl group, isononyl group, decyl group, isodecyl group, undecyl group, lauryl group, tridecyl group, tetradecyl group, stearyl group, octadecyl group, or dodecyl group. These alkyl (meth) acrylates may be used either as one kind or as a combination of two or more kinds.

The monomer components other than the above may be, for example, a carboxyl-containing monomer such as acrylic acid, methacrylic acid, carboxyethyl (meth)acrylate, carboxypentyl (meth)acrylate, itaconic acid, maleic acid, fumaric acid, or crotonic acid, an acid anhydride monomer such as maleic anhydride or itaconic anhydride, a hydroxyl-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, or (4-hydroxymethylcyclohexyl)methyl (meth)acrylate, a sulfonic-acid group-containing monomer such as styrene sulfonic acid, allyl sulfonic acid, 2-(meth)acrylamide-2-methylpropane sulfonic acid, (meth)acrylamidepropane sulfonic acid, sulfopropyl (meth)acrylate, or (meth)acryloyloxynaphthalene sulfonic acid, a phosphoric acid group-containing monomer such as 2-hydroxyethylacryloyl phosphate, or the like. These may be used either as one kind or as a combination of two or more kinds.

In addition, for the purpose of crosslinking of acrylic polymer or the like, multifunctional monomers and the like may be added as required as monomer component for copolymerization. Examples of such monomer include hexane diol di(meth)acrylate and (poly)ethylene glycol di(meth)acrylate, (poly)propylene glycol di(meth)acrylate and neopentyl glycol di(meth)acrylate, pentaerythritol di(meth)acrylate and trimethylol propane tri(meth)acrylate, pentaerythritol hexatri (meth)acrylate and dipentaerythritol hexa(meth)acrylate, epoxy acrylate and polyester acrylate, urethane acrylate, and others. One type or two or more types of multifunctional monomer may be used. The amount of use is preferably 30 wt. % or less of the total monomer from the viewpoint of adhesive characteristics or the like, especially preferably 20 wt.% or less.

The preparation of the (meth)acrylic polymer can be carried out by a suitable method such as the solution polymerization method, the emulsion polymerization method, the bulk polymerization method, or the suspension polymerization method, using a mixture containing one kind or two or more kinds of monomer components.

The polymerization initiator includes, but not particularly limited to, peroxide series such as hydrogen peroxide, benzoyl peroxide, and t-butyl peroxide. These polymerization initiators are preferably used alone; however, they may be used as a redox-based polymerization initiator by being combined with a reducing agent. The reducing agent includes, but not particularly limited to, ionized salts such as sulfite, hydrogen sulfite, iron salt, copper salt, and cobalt salt, amines such as triethanolamine, and reduced sugars such as aldose and ketose. Also, an azo compound can be used as a preferable polymerization initiator. The azo compound to be used includes, but not particularly limited to, for example, 2,2'-azobis-2-methylpropioamidinic acid salt, 2,2'-azobis-2,4-dimethylvaleronitrile, 2,2'-azobis-N,N'-dimethyleneisobutylamidinic acid salt, 2,2'-azobisisobutyronitrile, 2,2'-azobis-2-methyl-N-(2-hydroxyethyl)propionamide, or the like. Here, these polymerization initiators may be used either alone as one kind or as a combination of two or more kinds.

The reaction temperature at the time of preparing the (meth)acrylic polymer is not particularly limited; however, it is typically 50 to 85°C. Also, the reaction time is not particularly limited; however, it is typically 1 to 8 hours. Also, among the above-mentioned polymerization methods, the solution polymerization method is preferable. In this case, as a solvent for the (meth)acrylic polymer, a polar solvent such as ethyl acetate or toluene is typically used. Also, the solution concentration is not particularly limited; however, it is typically about 20 to 80 wt%.

To the pressure-sensitive adhesive agent, a cross-linking agent may be suitably added in order to raise the weight-average molecular weight of the (meth)acrylic polymer serving as the base polymer. The cross-linking agent includes, but not particularly limited to, polyisocyanate compounds, epoxy compounds, aziridine compounds, melamine resins, urea resins, anhydride compounds, polyamines, carboxyl group-containing polymers, and the like as examples. The amount of use of the cross-linking agent is typically such that 0.01 to 5 parts by weight are preferably blended relative to 100 parts by weight of the aforesaid base polymer in consideration of not letting the peeling-off adhesive strength be lowered too much.

Also, to the pressure-sensitive adhesive agent, commonly used additives such as various kinds of conventionally known tackifiers, anti-aging agents, fillers, and coloring agents may be added in addition to the aforesaid components in accordance with the needs.

The (meth)acrylic polymer is preferred to be suppressed in the content of low molecular weight substance from the viewpoint of prevention of contamination on the work, and the number-average molecular weight of the acrylic polymer is preferably 300,000 or more, or more preferably 400,000 to 3,000,000.

In order to prevent peeling-off by the laser light at the time of processing and to improve the property of peeling-off from the workpiece chip at the time of subsequent peeling-off, the pressure-sensitive adhesive agent may be a radiation-curing type pressure-sensitive adhesive agent that is cured by ultraviolet rays, electron beams, or the like. Here, in the case of using a radiation-curing type pressure-sensitive adhesive agent as the pressure-sensitive adhesive agent, it is preferable that the substrate 2b has a sufficient radiation-transmitting property because radiation is radiated onto the pressure-sensitive adhesive layer 2a after the laser processing.

The radiation-curing type pressure-sensitive adhesive agent to be used includes a pressure-sensitive adhesive agent having a radiation-curing type functional group such as a carbon-carbon double bond and exhibiting adhesiveness without any particular limitation. The radiation-curing type pressure-sensitive adhesive agent includes a radiation-curing type pressure-sensitive adhesive agent obtained by blending a radiation-curing monomer component or oligomer component into the aforesaid (meth)acrylic polymer.

The radiation curing type adhesive is prepared, for example, by blending the acrylic polymer with radiation curing monomer component or oligomer component. Examples of monomer component or oligomer component of radiation curing type to be blended include urethane; (meth)acrylate oligomer, trimethylol propane tri(meth)acrylate, tetramethylol methane tetra(meth)acrylate, tetraethylene glycol di(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate, 1,6-hexane diol (meth)acrylate, and other ester compounds of (meth)acrylate and polyhydric alcohol; 2-propenyl-3-butenyl cyanurate, tris(2-methacryloxy ethyl) isocyanurate, and other isocyanurate or isocyanurate compounds. These may be used either alone as one kind or as a combination of two or more kinds.

The blending amount of the radiation-curing monomer component or oligomer component is not particularly limited; however, in consideration of the adhesiveness, it is preferably about 5 to 500 parts by weight, more preferably about 70 to 150 parts by weight, relative to 100 parts by weight of the base polymer such as the (meth)acrylic polymer constituting the pressure-sensitive adhesive agent.

Also, the radiation-curing type pressure-sensitive adhesive agent to be used includes a base polymer having a carbon-carbon double bond in a polymer side chain, in the main chain, or at the main chain terminal. As such a base polymer, those having a (meth)acrylic polymer as a basic skeleton are preferable. In this case, there is no particular need to add a radiation-curing monomer component or oligomer component, and the use thereof is arbitrary.

The aforementioned radiation-curing type pressure-sensitive adhesive agent is allowed to contain a photopolymerization initiator in the case of being cured by ultraviolet rays or the like. The aforesaid photopolymerization initiator includes acetophenone-based compounds such as 4-(2-hydroxyethoxy)phenyl(2-hydroxy-2-propyl)ketone, α-hydroxy-α,α-methylacetophenone, methoxyacetophenone, 2,2-dimethoxy-2-phenylacetophenone, 2,2-diethoxyacetophenone, 1-hydroxycyclohexylphenylketone, and 2-methyl-1-[4-(methylthio)phenyl]-2-morpholinopropane-1, benzoin ether-based compounds such as benzoin ethyl ether, benzoin isopropyl ether, and anizoin methyl ether, α-ketol-based compounds such as 2-methyl-2-hydroxypropylphenone, ketal-based compounds such as benzyl dimethyl ketal, aromatic sulfonyl chloride-based compounds such as 2-naphthalenesulfonyl chloride, optically active oxime-based compounds such as 1-phenone-1,1-propanedione-2-(o-ethoxycarbonyl)oxime, benzophenone-based compounds such as benzophenone, benzoylbenzoic acid, and 3,3'-dimetyl-4-methoxybenzophenone, thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone, camphorquinone, halogenated ketone, acylphosphinoxide, acylphosphonate, and others as examples.

The content of photopolymerization initiator is preferred to be 0.1 to 10 parts by weight in 100 parts by weight of base polymer (acrylic polymer), especially preferably 0.5 to 5 parts by weight.

Control of crosslinking density of the pressure-sensitive adhesive layer is realized by any proper method, including crosslinking method by using an appropriate crosslinking agent such as multifunctional isocyanate compound, epoxy compound, melamine compound, metal salt compound, metal chelate compound, amino resin compound, or peroxide, and crosslinking method by irradiation of energy ray by mixing low molecular compound having two or more carbon-carbon double bonds.

As a method for disposing the pressure-sensitive adhesive layer 2a on the substrate 2b, a known technique may be adopted. For example, a suitable method is used such as a method of direct application onto the substrate 2b or a method of transcribing a pressure-sensitive adhesive agent disposed on a sheet on which a releasing agent has been applied. The pressure-sensitive adhesive layer 2a may be a single layer or a laminate of two or more layers. Here, the thickness of the pressure-sensitive adhesive layer 2a can be suitably selected within a range such that the pressure-sensitive adhesive layer 2a is not peeled off from the workpiece and the adherend serving as an object. Typically, the thickness is about 2 to 300 $\mu$m, preferably about 5 to 100 $\mu$m, more preferably about 10 to 50 $\mu$m.

Also, the adhesive strength of the pressure-sensitive adhesive layer is preferably 20 N/20 mm or less, more preferably 0.001 to 10 N/20 mm, still more preferably 0.01 to 8 N/20 mm. These values are based on the adhesive strength (90 degrees peel value, peeling-off speed of 300 mm/min) to SUS304 at an ordinary temperature (before laser radiation).

The pressure-sensitive adhesive sheet 2 of the present invention can be produced, for example, by applying an pressure-sensitive adhesive agent solution onto a surface of the substrate 2b and drying (and heating for cross-linking in accordance with the needs) to form the pressure-sensitive adhesive layer 2a. Also, a method of forming a pressure-sensitive adhesive layer 2a separately on a release liner and bonding it onto the substrate 2b may be adopted. Further, for label processing or protecting the pressure-sensitive adhesive layer 2a, a separator may be provided on the surface of the pressure-sensitive adhesive layer 2a in accordance with the needs.

The aforesaid separator includes paper or synthetic resin film such as polyethylene, polypropylene, or polyethylene terephthalate. In order to enhance the releasing property to the pressure-sensitive adhesive layer 2a, a releasing treatment such as a silicone treatment, a long-chain alkyl treatment, or a fluorine treatment may be carried out on the surface of the separator in accordance with the needs. Also, in order to prevent the pressure-sensitive adhesive layer 2a from being radiation-cured by environmental ultraviolet rays, an ultraviolet transmittance prevention treatment or the like may be carried out in accordance with the needs. The thickness of the separator is not particularly limited; however, it is typically 10 to 200 $\mu$m, preferably 25 to 100 $\mu$m.

Next, the laser processing method of the present invention will be described. The laser processing method according to the present embodiment is a laser processing method using a pressure-sensitive adhesive sheet 2 by radiating laser light onto a workpiece so as to process the workpiece by ablation. Specifically, the method includes a step of bonding the pressure-sensitive adhesive sheet 2 onto the workpiece through the intermediary of an pressure-sensitive adhesive layer 2a, and a step of processing the workpiece by radiating onto the workpiece the laser light having a radiation intensity of a threshold value that induces at least the ablation of the workpiece or higher.

The adhering step of the pressure-sensitive adhesive sheet and the work is realized by any know method using roll laminator, press, or the like. To adhere, a pressure-sensitive adhesive layer is adhered to the opposite side of the processing surface of the work.

The processing step of the work is laser processing of the work by using laser beam by ablation. In this process, it is preferred to use the laser beam of which wavelength is in ultraviolet region. It is more preferable to use laser beam inducing photochemical ablation without resort to thermal processing. It is further preferred to use a laser beam capable of cutting by focusing in a narrow width of 20 $\mu$m or less. By using such laser beam, thermal damage by laser processing can be avoided, and the precision of hole edge or cut section wall can be enhanced, and the appearance is improved.

The laser beam is preferred to be within 2 times of the irradiation intensity for forming a through-hole in the work, at higher than the irradiation intensity of threshold for inducing ablation of the work. It is preferred to use pulse laser.

Such laser beam is preferred to induce ablation by ultraviolet absorption of 400 nm or less. Specific examples are KrF excimer laser (oscillation wavelength 248 nm), XeCl excimer laser (308 nm), YAG laser third harmonic (355 nm) or fourth harmonic (266 nm), YLF (yttrium lithium fluoride) or $YVO_4$ (yttrium vanadiate) or other solid laser third harmonic or fourth harmonic, and other laser beam having oscillation wavelength at 400 nm or less. If the wavelength is over 400 nm, the laser may be preferably used if capable of absorbing light in ultraviolet region after the multiple photon absorption process, and capable of cutting in a width of 20 $\mu$m or less by multiple photon absorption ablation, such as titanium sapphire laser with wavelength around 750 nm to 800 nm and pulse width of $le^{-9}$ sec (0.000000001 sec) or less.

When using fundamental wave (wavelength 1.06 $\mu$m) of YAG laser or ruby laser (wavelength 694 nm), if focused, the beam diameter can be reduced only to about 50 $\mu$m. On the other hand, as in the exemplary embodiment, when laser beam in ultraviolet region is used, the beam diameter can be further reduced (for example, about 20 $\mu$m). Therefore, wide allowance is not needed when cutting.

The processing in this step is shaping, for example, cutting, drilling, marking, grooving, scribing, or trimming. The cutting process is conducted as shown in Fig. 1 and Fig. 2. Fig. 1 is a schematic diagram explaining the cutting process of the work according to the exemplary embodiment. Fig. 2 is a sectional view showing the cutting process of the exemplary embodiment.

The work 3 shown in Fig. 1 and Fig. 2 is a laminated body of a workpiece 1 and a pressure-sensitive adhesive sheet 2. The pressure-sensitive adhesive sheet 2 is composed of a base material 2b and a pressure-sensitive adhesive layer 2a provided thereon. The workpiece 1 and pressure-sensitive adhesive sheet 2 are adhered by known method using roll laminator, press or the like. In the cutting process, the work 3 is fixed on a suction plate 5 of a suction stage 4. A laser beam 6 produced from a specified laser oscillator is focused by a lens, and emitted to the work. Simultaneously with emission, the laser emitting position is moved along the specified processing line, and cutting process is carried out. Cutting process includes laser machining using galvanoscan or X-Y stage scan, mask imaging laser process, and other known laser machining methods.

Laser processing condition is not particularly specified as far as the workpiece 1 can be cut off completely. That is, the optimum value of irradiation intensity can be determined on the basis of the ablation threshold of the material of the work. However, to avoid cutting of the pressure-sensitive adhesive sheet 2, it is preferred to be within 2 times of the processing condition for forming a through-hole in the workpice 1. The cutting allowance can be narrowed by reducing the beam diameter of the focusing part of laser beam, but in order to enhance the cut section, it is preferred to satisfy the following condition.

Beam diameter ($\mu$m) > 2 $\times$ (laser beam moving speed ($\mu$m/sec)/ laser repetition frequency (Hz))

If the pressure-sensitive adhesive sheet 2 is not adhered to the reverse side of the workpiece 1, decomposition scraps from the workpice 1 and suction stage 4 stick around the cut edge of the laser exit side of the laser processed part. Such contamination can be prevented by adhering the pressure-sensitive adhesive sheet 2 of the exemplary embodiment.

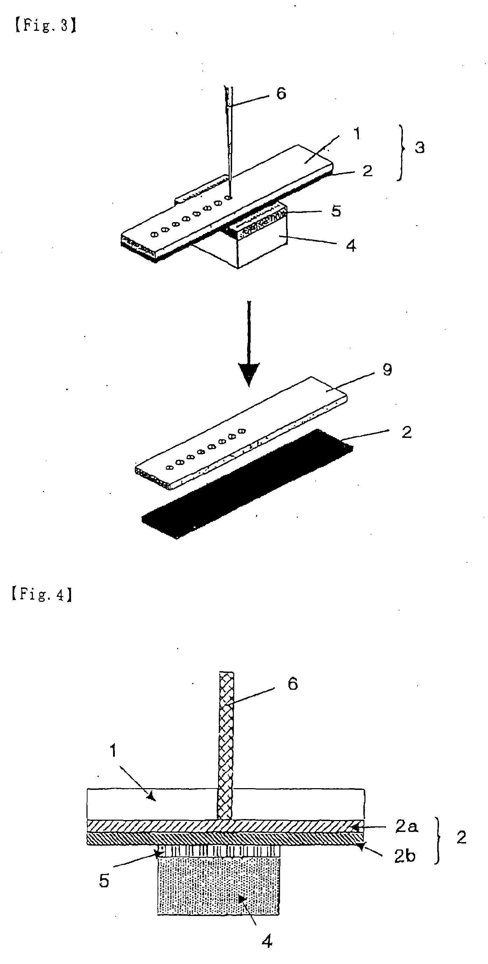

Drilling process is conducted as shown in Fig. 3. Fig. 3 is a schematic diagram explaining the drilling process of the work in the exemplary embodiment. Drilling process includes laser machining using galvanoscan or X-Y stage scan, mask imaging punching process, and other known laser machining methods.

In this step, laser processable sheet or other pressure-sensitive adhesive sheet may be adhered to the laser incident side. Further, helium, nitrogen, oxygen or other gas may be blown to the machining area by using laser. As a result, residue on the work surface at the laser incident side can be removed easily.

Peeling process of the pressure-sensitive adhesive sheet is a step of peeling off the pressure-sensitive adhesive sheet from the work after machining (the laser processed part 9 shown in Fig. 2 and Fig. 3). Peeling method is not particularly specified, and any known method may be applied. However, it is preferred to avoid excessive stress to cause permanent deformation of the work when peeling. Therefore, from the viewpoint of elimination of stress, for example, a pressure-sensitive adhesive sheet lowered in adhesion by irradiation with radiation or heating may be used. Such pressure-sensitive adhesive sheet has both holding force when processing and ease of peeling. When a radiation curing type adhesive is used in the pressure-sensitive adhesive layer of the pressure-sensitive adhesive, the pressure-sensitive adhesive layer is cured and the adhesion is lowered by emitting radiation depending on the type of the adhesive. By irradiation with radiation, the adhesion of the pressure-sensitive adhesive layer is lowered by curing, and it is easier to peel. Irradiation means of radiation is not particularly specified, and, for example, ultraviolet ray is emitted.

In the case of cutting process (dicing) of semiconductor wafer, as shown in Fig. 4, one side of the semiconductor wafer (work) 7 is adhered to the pressure-sensitive adhesive sheet 2 for laser processing provided on the suction stage 4, and it is fixed to the dicing frame 8. A laser beam 6 produced from a specified laser oscillator is focused by a lens, and emitted to the semiconductor wafer 7, and the laser emitting position is moved along the specified processing line, and cutting process is carried out. Laser beam moving means includes galvanoscan or X-Y stage scan, mask, imaging, and other known laser machining methods. Processing condition of semiconductor wafer 7 is not particularly specified as far as the semiconductor wafer 7 is cut off and the pressure-sensitive adhesive sheet 2 is not cut off. A protective sheet may be provided at the laser beam incident side of the semiconductor wafer 7.

In such dicing process of semiconductor wafer 7, after cutting into individual semiconductor chips (laser processed parts), the individual semiconductor chips can be picked up and collected by a pickup method using a push-up pin called needle by a known device such as die bonder, or by a known method disclosed in Japanese Laid-open Patent No. 2001-118862.

In the exemplary embodiment, the work to be processed by laser is not particularly specified as far as it can be processed by laser by ablation, using laser beam. Applicable examples include sheet materials, circuit board, semiconductor wafer, glass substrate, ceramic substrate, metal substrate, semiconductor laser or other light emitting or receiving element substrates, MEMS (micro electro mechanical system) substrates, semiconductor packages, cloth, leather, paper or the like. Sheet materials include polyimide resin, polyester resin, epoxy resin, urethane resin, polystyrene resin, polyethylene resin, polyamide resin, polycarbonate resin, silicone resin, fluoroplastic resin, macromolecular film, nonwoven cloth, these resins provided with physical or optical functions by drawing process or impregnating process, copper, aluminum, stainless steel, other metal sheets, and polymer sheet and/or metal sheet laminated directly or by way of adhesive or the like. Circuit boards include one-side or both-side or multilayer flexible printed board, rigid substrate made of glass epoxy, ceramics, metal core substrate or the like, and optical circuit or opto-electrical mixed circuit formed on glass or polymer. A specified pressure-sensitive adhesive is adhered to the opposite side of the laser irradiation surface of the work prepared in this manner.

Hereafter, the present invention will be described with reference to the examples; however, the present invention is not limited to the following examples as long as it does not go beyond the gist thereof.

(Measurement of the etching rate of a substrate)

The measurement of the etching rate on the back surface side of the substrate was carried out as follows. The third harmonic (wavelength: 355 nm) of a YAG laser (maximum output: 5W, repetition frequency: 30 kHz) subjected to beam shaping in a top hat shape was condensed by a fθ lens, and was radiated respectively onto the surfaces of the substrate and the pressure-sensitive adhesive layer under a condition of the pulse number of 200 (pulse). After the radiation, the depth (μm) of the hole formed in the substrate and the pressure-sensitive adhesive layer was measured by an optical microscope. On the basis of this measured value, the etching speed was calculated by the following formula. The result is shown in the following Table 1.

$$\text{Etching speed = hole depth (μm) / pulse number (pulse)}$$

Also, the etching rate was calculated by the following formula from the etching speed and the energy fluence. The result is shown in the following Table 1.

$$\text{Etching rate = etching speed (μm / pulse) / energy fluence (J/cm}^2\text{)}$$

(measurement of light absorption coefficient)

The light absorption coefficient of the sheet-shaped pressure-sensitive adhesive agent and the substrate at the wavelength of 355 nm was measured by the following method. In other words, with use of an ultraviolet visible optical spectrometer UV-2550 (manufactured by SHIMADZU Corporation), the sheet-shaped pressure-sensitive adhesive agent or the substrate was mounted onto a jig, and the transmittance T % and the reflectance R % to the laser light having a wavelength of 355 nm were measured, so as to perform the following calculation. The result is shown in the following Table 1.

$$\text{T' = T / (100 - R) × 100}$$

$$\text{Light absorption coefficient [cm}^{-1}\text{] = LN (1 / T') / thickness of the sheet-shaped pressure-sensitive adhesive agent or the substrate [cm]}$$

(Example 1)

An acrylic pressure-sensitive adhesive agent solution was applied onto a substrate made of polyethylene (thickness 100 μm, etching rate from the back surface side of the substrate: 0 [(μm / pulse) / (J/cm$^2$)], melting point of the back surface side: 98°C, light absorption coefficient of the substrate: 5.7), followed by drying to form an pressure-sensitive adhesive layer (thickness: 10 μm) so as to obtain an pressure-sensitive adhesive sheet for laser processing.

Here, the acrylic pressure-sensitive adhesive agent solution was prepared by the following method. An acrylic-based pressure-sensitive adhesive agent solution was prepared by adding 100 parts by weight of acrylic polymer having a weight-average molecular weight of 500,000 obtained by copolymerizing butyl acrylate / ethyl acrylate / 2-hydroxyethyl acrylate / acrylic acid in a weight ratio of 60 / 40 / 4 / 1, 3 parts by weight of an isocyanate-based cross-linking agent (CORONATE HL manufactured by Nippon Polyurethane Industry Co., Ltd.), and 2 parts by weight of an epoxy-based cross-linking agent (TETRAD C manufactured by Mitsubishi Gas Chemical Company., Inc.) to 500 parts by weight of toluene, followed by uniformly dissolving and mixing.

Here, the weight-average molecular weight of the synthesized acrylic-based polymer was measured by the following method. In other words, the synthesized acrylic-based polymer was dissolved into THF at 0.1 wt%, and the weight-average molecular weight was measured by polystyrene conversion using GPC (Gel Permeation Chromatography). The measurement condition was set to be GPC apparatus: HLC-8120GPC manufactured by TOSO Corporation, column; (GMHHR-H) + (GMHHR-H) + (G2000HHR) manufactured by TOSO Corporation, flow rate: 0.8 ml/min, concentration: 0.1 wt%, injection amount: 100 $\mu$l, column temperature: 40°C, eluent: THF).

(Example 2)

In the present Example 2, an pressure-sensitive adhesive sheet for laser processing was fabricated in the same manner as in the Example 1 except that a substrate (thickness: 100 $\mu$m, etching rate from the back surface side of the substrate: 0, melting point of the resin layered on the back surface: 98°C, light absorption coefficient of the substrate: 6.3) obtained by laminating polyethylene (thickness: 50 $\mu$m) onto the back surface side of ethylene vinyl acetate copolymer (vinyl acetate ratio: 10%, thickness: 50 $\mu$m) was used as the substrate of the pressure-sensitive adhesive sheet.

(Example 3)

In the present Example 3, an pressure-sensitive adhesive sheet for laser processing was fabricated in the same manner as in the Example 1 except that a substrate (thickness: 100 $\mu$m, etching rate from the back surface side of the substrate: 0, melting point of the resin layered on the back surface: 98°C, light absorption coefficient of the substrate: 4.8) obtained by laminating polyethylene (thickness: 50 $\mu$m) onto the back surface side of polypropylene (thickness: 50 $\mu$m) was used as the substrate of the pressure-sensitive adhesive sheet.

(Comparative Example 1)

In the present Comparative Example 1, an pressure-sensitive adhesive sheet for laser processing was fabricated in the same manner as in the Example 1 except that a substrate (thickness: 100 $\mu$m, etching rate from the back surface side of the substrate: 0.8, melting point of the resin layered on the back surface: 140°C, light absorption coefficient of the substrate: 4.8) obtained by laminating polypropylene (thickness: 50 $\mu$m) onto the back surface side of polyethylene (thickness: 50 $\mu$m) was used as the substrate of the pressure-sensitive adhesive sheet.

(Comparative Example 2)

In the present Comparative Example 2, an pressure-sensitive adhesive sheet for laser processing was fabricated in the same manner as in the Example 1 except that a substrate (thickness: 100 $\mu$m, etching rate from the back surface side of the substrate; 0, melting point of thy resin layered on the back surface: 75°C, light absorption coefficient of the substrate: 6.3) obtained by laminating ethylene vinyl acetate copolymer (vinyl acetate ratio: 10%, thickness: 50 $\mu$m) onto the back surface side of polyethylene (thickness: 50 $\mu$m) was used as the substrate of the pressure-sensitive adhesive sheet.

(laser processing)

A silicon mirror wafer having a thickness of 100 $\mu$m was used as a workpiece. The pressure-sensitive adhesive sheets that were fabricated respectively in the aforesaid examples and comparative examples were bonded onto a roll laminator so that the pressure-sensitive adhesive layer would be a pressure-sensitive adhesive surface. Further, these samples were placed quietly onto an X-Y stage on which a table made of glass was mounted in a processing apparatus so that the silicon mirror wafer would be the upper side.

Next, the third harmonic (355 nm) of a YAG laser having an average output of 5W and a repetition frequency of 30 kHz was condensed to a 25 $\mu$m diameter by an f$\theta$ lens, and the laser light was scanned at a speed of 20 mm/sec by a galvanoscanner to perform a cutting process. At this time, the presence or absence of fusion between the substrate in the pressure-sensitive adhesive sheet and the glass table was confirmed. The case in which there was no fusion was evaluated as being good, and the case in which there was fusion was evaluated as being poor. The result is shown in the following Table 1.

Table 1

|  | Example 1 | Example 2 | Example 3 | Comparative Example 1 | Comparative Example 2 |
|---|---|---|---|---|---|
| Etching rate of the back surface side of the substrate | 0 | 0 | 0 | 0.8 | 0 |
| Melting point of the back surface side of the substrate | 98 | 98 | 98 | 140 | 75 |
| Light absorption coefficient of the substrate | 5.7 | 6.3 | 4.8 | 4.8 | 6.3 |
| fusion onto the glass table | good | good | good | poor | poor |

**Claims**

1. A pressure-sensitive adhesive sheet for laser processing that is used for laser processing of a workpiece with laser light having a wavelength in an ultraviolet region or with laser light that enables light absorption in an ultraviolet region that has passed a multiphoton absorption process, comprising a substrate and an pressure-sensitive adhesive layer disposed on one surface of the substrate, wherein a melting point of the substrate at another surface is 80°C or higher, and an etching rate (etching speed / energy fluence) in a case of radiating the laser light onto the other surface is 0.1 [($\mu$m /pulse) /(J/cm$^2$)] or lower.

2. The pressure-sensitive adhesive sheet for laser processing according to claim 1, wherein a light absorption coefficient of the substrate is 10 (1 / cm) or lower for the laser light having a predetermined oscillation wavelength.

3. The pressure-sensitive adhesive sheet for laser processing according to claim 1 or 2, wherein the substrate is a laminate, and a layer made of polyethylene is disposed on the other surface side.

4. The pressure-sensitive adhesive sheet for laser processing according to claim 3, wherein a thickness of the layer made of polyethylene is 5 $\mu$m or more.

5. The pressure-sensitive adhesive sheet for laser processing according to claim 1 or 2, wherein the substrate is made of a polyolefin resin.

6. The pressure-sensitive adhesive sheet for laser processing according to any one of claims 1 to 5, wherein a thickness of the substrate is 500 $\mu$m or less.

7. The pressure-sensitive adhesive sheet for laser processing according to any one of claims 1 to 6, wherein the pressure-sensitive adhesive layer is made of a radiation-curing type pressure-sensitive adhesive, and the substrate has a radiation transmitting property.

8. A laser processing method using an pressure-sensitive adhesive sheet for laser processing as set forth in any one of claims 1 to 7 by radiating onto a workpiece laser light having a wavelength in an ultraviolet region or laser light that enables light absorption in an ultraviolet region that has passed a multiphoton absorption process, so as to process the workpiece by ablation, comprising:

a step of bonding the pressure-sensitive adhesive sheet for laser processing onto the workpiece through the intermediary of the pressure-sensitive adhesive layer; and
a step of processing the workpiece by radiating onto the workpiece the laser light having a radiation intensity of a threshold value that induces at least the ablation of the workpiece or higher.

9. The laser processing method according to claim 8, wherein the workpiece is a semiconductor wafer, and semiconductor chips are formed by splitting the semiconductor wafer into individual pieces by radiation of the laser light.

10. The laser processing method according to claim 8 or 9, wherein laser light having a radiation intensity within a double of a radiation intensity at which a through-hole is formed in the workpiece is used as the laser light.

11. The laser processing method according to any one of claims 8 to 10, wherein a beam diameter of the laser light that is radiated onto the workpiece is 20 $\mu$m or less.

12. The laser processing method according to any one of claims 8 to 11, wherein a radiation condition of the laser light that is radiated onto the workpiece is a relationship represented by the following formula:

$$\text{beam diameter } (\mu m) > 2 \times (\text{laser light moving speed}$$
$$(Am / sec) / \text{repetition frequency of the laser light } (Hz)).$$

13. The laser processing method according to any one of claims 8 to 12, wherein laser light having an oscillation wavelength of 400 nm or less is used as the laser light.

14. The laser processing method according to any one of claims 8 to 13, wherein laser light having an oscillation wavelength of 750 to 800 nm and having a pulse width of $1 \times e^{-9}$ second or less is used as the laser light.

【Fig. 1】

6

1

2a
2b
} 2

【Fig. 2】

6

1
2
} 3

5
4

1

9

2

[Fig. 3]

[Fig. 4]

[Fig. 5]

**EUROPEAN SEARCH REPORT**

Application Number

EP 09 00 7723

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2006 160996 A (NITTO DENKO CORP) 22 June 2006 (2006-06-22) | 1-13 | INV. B23K26/18 |
| Y | * abstract; figures; examples * | 14 | B23K26/40 C09J7/02 |
| Y | US 2008/108262 A1 (F. ASAI ET AL) 8 May 2008 (2008-05-08) * paragraph [0023] * | 14 | H01L21/68 H01L21/78 |
| X | EP 1 634 673 A (NITTO DENKO CORPORATION) 15 March 2006 (2006-03-15) * paragraphs [0119] - [0122], [0149] - [0152]; figures; examples 8-1,8-2 * | 1-11,13, 14 | |
| X | JP 2006 111659 A (NITTO DENKO CORP) 27 April 2006 (2006-04-27)  * abstract; figures; example 1 * | 1,2, 5-10,12, 13 | |
| X | EP 1 184 437 A (3M INNOVATIVE PROPERTIES COMPANY) 6 March 2002 (2002-03-06) * claims 1,4,8,9; figures * | 1-7 | TECHNICAL FIELDS SEARCHED (IPC) |
| X | DE 44 02 444 A1 (MINNESOTA MINING & MFG. CO.) 3 August 1995 (1995-08-03) * page 4, line 67 - page 5, line 3; claims 1-3 * | 1,2,5,6 | B23K C09J H01L |

The present search report has been drawn up for all claims

| Place of search | Date of completion of the search | Examiner |
|---|---|---|
| Munich | 13 August 2009 | Jeggy, Thierry |

EPO FORM 1503 03.82 (P04C01)

## ANNEX TO THE EUROPEAN SEARCH REPORT
## ON EUROPEAN PATENT APPLICATION NO.

EP 09 00 7723

This annex lists the patent family members relating to the patent documents cited in the above-mentioned European search report.
The members are as contained in the European Patent Office EDP file on
The European Patent Office is in no way liable for these particulars which are merely given for the purpose of information.

13-08-2009

| Patent document cited in search report | | Publication date | Patent family member(s) | | Publication date |
|---|---|---|---|---|---|
| JP 2006160996 | A | 22-06-2006 | NONE | | |
| US 2008108262 | A1 | 08-05-2008 | CN | 101177598 A | 14-05-2008 |
| | | | EP | 1918343 A1 | 07-05-2008 |
| | | | JP | 2008117945 A | 22-05-2008 |
| | | | KR | 20080041123 A | 09-05-2008 |
| EP 1634673 | A | 15-03-2006 | WO | 2004096483 A1 | 11-11-2004 |
| | | | KR | 20060008921 A | 27-01-2006 |
| | | | US | 2006246279 A1 | 02-11-2006 |
| JP 2006111659 | A | 27-04-2006 | NONE | | |
| EP 1184437 | A | 06-03-2002 | NONE | | |
| DE 4402444 | A1 | 03-08-1995 | WO | 9520633 A1 | 03-08-1995 |

EPO FORM P0459

For more details about this annex : see Official Journal of the European Patent Office, No. 12/82

**EP 2 133 170 A1**

**Patent documents cited in the description**

- JP 2004079746 A
- JP 2002393797 A
- JP 2001118862 A